# EUROPEAN PATENT APPLICATION

(11) **EP 3 929 982 A1**
(43) Date of publication of application: **29.12.2021**
(21) Application number: 21151430.2
(22) Date of filing: 13.01.2021
(51) Int. Cl.: H01L 27/02, H02H 9/04

(54) **INTEGRATED CIRCUIT DEVICE INCLUDING ELECTROSTATIC DISCHARGE PROTECTION AND CURRENT LIMITING CIRCUITRY**

(30) Priority: 26.06.2020 US 202016913887
(71) Applicant: INTEL Corporation, Santa Clara, CA 95054 (US)
(72) Inventor: VU, Lan, San Jose, California 95120 (US); HAIDER, Nazar, Fremont, California CA 94539 (US); POON, Steven, Portland, Oregon 97225 (US); XU, Shunjiang, Milpitas, California 95035 (US); SEWANI, Aman, Sunnyvale, California 94086 (US)
(74) Representative: HGF

(57) **Abstract**

Some embodiments include apparatuses having an input node; an electrostatic discharge protection circuitry including a first diode including a cathode coupled to the input node, and an anode coupled to a ground node; a second diode including an anode coupled to the input node, and a cathode coupled to a circuit node; a clamp circuit coupled to the circuit node; and a current limiting circuit coupled between the circuit node and a supply node.

## Description

### TECHNICAL FIELD

Embodiments described herein pertain to integrated circuit (IC) devices and systems. Some embodiments relate to electrostatic discharge (ESD) protection in such devices and systems.

### BACKGROUND

In electronic devices and systems (e.g., IC chips, cellular phones, and computers), an ESD event occurs when a relatively high electrostatic charge buildup in an object (or in human) is transferred to the device or system through direct contact or, in some cases, through air. The voltage associated with such an ESD event can be in the range of thousands of kilovolts. This high voltage can damage the device and system. Therefore, many devices and systems have ESD protection circuitry to protect them from ESD events. As described in more detail below, some non-ESD may inadvertently create a short between circuit elements of the ESD protection circuitry and other circuitry of the device. Prolonged duration of such a short can cause irreversible physical damage to the device.

### BRIEF DESCRIPTION OF THE DRAWINGS

FIG. 1A shows an apparatus including a device having an ESD protection circuitry and current limiting circuitry, according to some embodiments described herein.
FIG. 1B shows an IC package and conductive connections on the IC package of the device of FIG. 1A, according to some embodiments described herein.
FIG. 2 shows details of the ESD protection circuitry and the current limiting circuitry of the device of FIG. 1A, according to some embodiments described herein.
FIG. 3 shows a device having ESD protection circuitry and shared current limiting circuitry, according to some embodiments described herein.
FIG. 4 shows another device having ESD protection circuitry and shared current limiting circuitry.
FIG. 5 shows an apparatus in the form of a system, according to some embodiments described herein.

### DETAILED DESCRIPTION

The techniques described herein relate to a device that includes ESD protection circuitry to protect the device from ESD events and current limiting circuitry to protect the device from non-ESD events. Some conventional techniques for ESD protections for certain electrical components in the device use large on-die capacitance that can incur significant device area penalty. Other conventional techniques for ESD protections use only clamp circuits without diodes. This can cause temperature dependent leakage leading to error in certain operations in the device. Some other conventional techniques for ESD protection may use strict power sequencing rules that sometimes may be unintentionally violated by devices having different power domains.

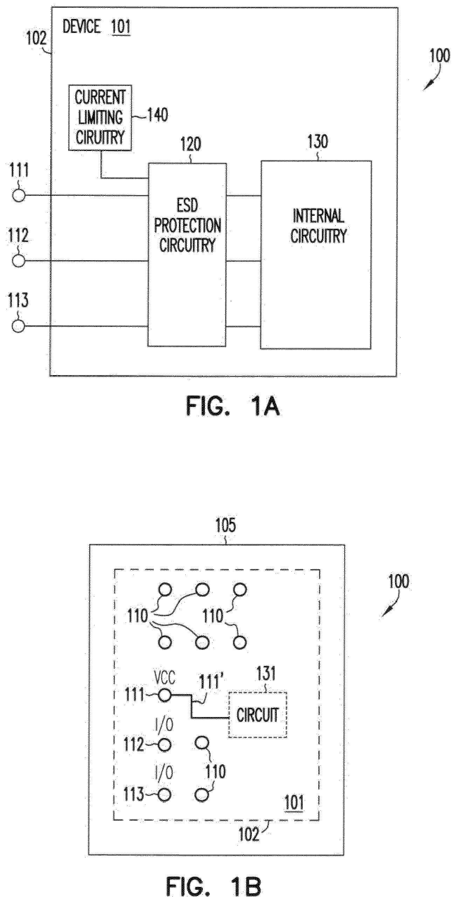

The techniques described herein include current limiting circuitry that can operate to control current on circuit paths involving circuit elements of ESD protection circuitry during non-ESD events without impacting ESD protection operations for ESD events. Operations of the current limiting circuitry can prevent electrical stress and physical damage in device 101 during non-ESD events. Other improvements and benefits are described below with reference to FIG. 1A through FIG. 5.

FIG. 1A shows an apparatus 100 including a device 101 having ESD protection circuitry 120, internal circuitry 130, and current limiting circuitry 140, according to some embodiments described herein. Apparatus 100 can include or be included in an electronic device or system, such as a computer (e.g., desktop, laptop, or notebook), a tablet, a cellular phone, or other electronic devices or systems. Device 101 can include an IC device (e.g., IC chip). For example, device 101 can include a processor, a memory device, a memory controller, a graphics controller, a system on chip (SoC), a system in a package (SiP), or other electronic devices or systems. Examples of a processor included in device 101 include embedded processors, mobile processors, micro-controllers, digital signal processors, superscalar computers, vector processors, single instruction multiple data (SIMD) computers, complex instruction set computers (CISC), reduced instruction set computers (RISC), very long instruction word (VLIW), hybrid architecture, and other architectures.

As shown in FIG. 1A, device 101 can include a die (e.g., IC die) 102. Die 102 can be a semiconductor (e.g., silicon) die. Circuit components of ESD protection circuitry 120 can be located on (e.g., formed in or formed on) the same die (e.g., die 102) with other circuitry of device 101.

Internal circuitry 130 of device 101 can include components of a processor (e.g., a central processing unit (CPU)), a memory device, or both. Thus, internal circuitry 130 can include circuits and logic components that can operate to process information (e.g., data), store information, or both. For example, internal circuitry 130 can include calculating circuitry to perform arithmetic functions (e.g., addition, subtraction, and multiplication), data transmission circuitry to perform data transmission functions (e.g., data multiplexing, data de-multiplexing, encoding, decoding), and other types of circuitry (e.g., circuitry in a CPU) to perform other functions (e.g., other functions in a CPU).

As shown in FIG. 1A, device 101 can include nodes 111, 112, and 113 coupled to ESD protection circuitry 120. Device 101 can use nodes 111, 112, and 113 to receive supply power (e.g., supply voltage) and information (e.g., data) in the form of signals at nodes 111, 112, and 113. FIG. 1A shows device 101 including three nodes 111, 112, and 113 as an example. However, device 101 can include more than three nodes similar to nodes 111, 112, and 113.

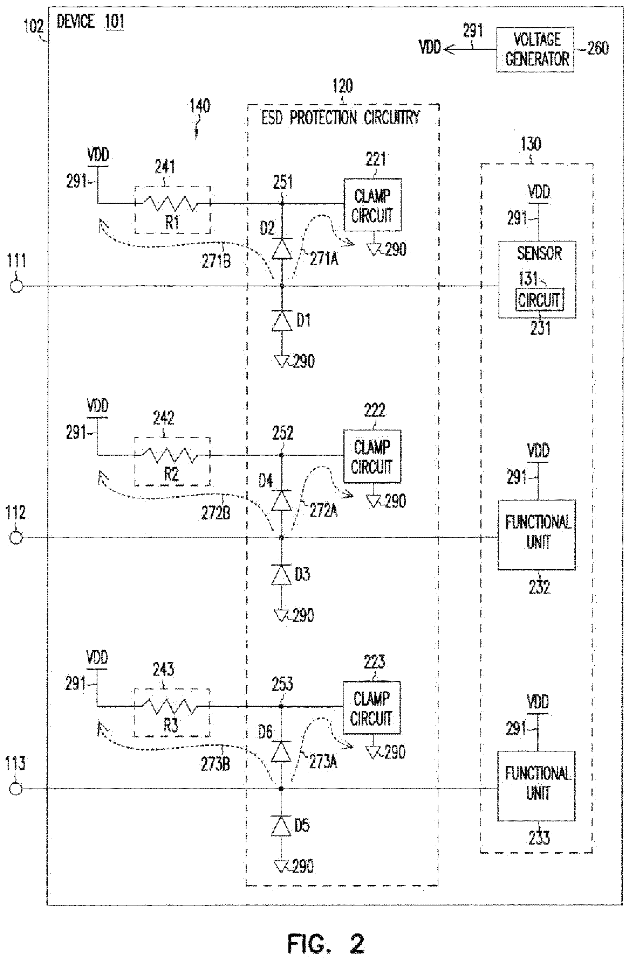

ESD protection circuitry 120 can operate to protect internal circuitry 130 from ESD events. Current limiting circuitry 140 can operate to control current on circuit paths involving circuit elements of ESD protection circuitry 120 during non-ESD events, as described below with reference to FIG. 2. FIG. 1A shows current limiting circuitry 140 separated from ESD protection circuitry 120 as an example. However, current limiting circuitry 140 can be part of ESD protection circuitry 120.

FIG. 1B shows a structure of device 101 including package 105 according to some embodiments described herein. Device 101 can include (or can be included in) in a package 105, which can be a CPU package, system-on-chip package, system-in-package, or other types of IC packages. Die 102 can be included in (e.g., enclosed in) package 105. As shown in FIG. 1B, device 101 can include nodes 110 besides nodes 111, 112, and 113. Nodes 110, 111, 112, and 113 can be conductive connections (e.g., conductive terminals) on package 105. For example, nodes 110, 111, 112, and 113 can be conductive pads, conductive pins, solder balls, solder bumps, or other types of conductive connections of the IC package device 101. For example, each of nodes 110, 111, 112, and 113 can be part of a conductive connection includes a controlled collapse chip connection (C4) structure.

Nodes 110, 111, 112, and 113 can be configured to receive supply power (e.g., supply voltages) and carry information (e.g., data). For example, as shown in FIG. 1B, node 111 can be configured to receive a voltage Vcc (e.g., supply voltage) that can be used as a supply voltage for device 101. Node 111 can be coupled to an external voltage source (e.g., off-chip power source, not shown in FIG. 1B) that provides voltage (e.g., supply voltage) Vcc to device 101 through node 111. Nodes 112 and 113 can be configured to carry information, such as output data signals transmitted by device 101 to another device, or input data signals sent to device 101 from another device.

Internal circuitry 130 (FIG. 1A) of device 101 can be coupled to (e.g., directly coupled to) some or all of nodes 110, 111, 112, and 113 on package 105. For example, FIG. 1B shows a circuit 131 (which is part of internal circuitry 130) can be coupled to node 111 through a conductive connection 111'. Conductive connection 111' can be metal wire, metal line (or trace), or other types of conductive connections coupled to node 111 and circuit 131.

FIG. 2 shows device 101 of FIG 1 including details of ESD protection circuitry 120 and current limiting circuitry 140, according to some embodiments described herein. As shown in FIG. 2, ESD protection circuitry 120 can include diodes D1, D2, D3, D4, D5, and D6, and clamp circuits 221, 222, and 223. Device 101 can include nodes (e.g., circuit nodes) 251, 252, and 253, a node (e.g., supply node) 291, and a ground node 290. Each of diodes D1, D2, D3, D4, D5, and D6 can have its anode and cathode coupled to nodes 111, 112, 113, 251, 252, 253, 291, and 290 in connections shown in FIG. 2.

Node 291 can be an internal supply node of device 101. For example, device 101 can include a voltage generator (e.g., internal voltage regular) 260 to generate a voltage (e.g., internal supply voltage) VDD. Voltage generator 260 can include an output node coupled to node 291 to provide voltage VDD at node 291. Voltage VDD at node 291 is different from voltage Vcc. As described above with reference to FIG. 1B, voltage Vcc can be provided to device 101 through node 111 from a voltage source outside device 101. The value of voltage VDD can be less than the value of voltage Vcc. FIG. 2 shows voltage VDD being generated internally by device 101 as an example. However, voltage VDD can be provided to device 101 from an external power supply.

As shown in FIG. 2, internal circuitry 130 can include a sensor (e.g., sensor circuit) 231, and functional units 232, and 233 coupled to nodes 111, 112, and 113, respectively. One or both of functional units 232 and 233 can include calculating circuitry, data transmission circuitry, and other types of circuitry as mentioned above with reference to FIG. 1A. As shown in FIG. 2, functional units 232 and 233 can be coupled to node 291 to receive voltage VDD. Functional units 232 and 233 can use voltage VDD as their supply voltage.

Circuit 131 (also shown in FIG. 1B) can be part of sensor 231. Sensor 231 can be coupled to node 291 to receive voltage VDD. Sensor 231 can use voltage VDD as its supply voltage. Sensor 231 can operate to monitor (e.g., sense) the level of the voltage (e.g., voltage Vcc) at node 111 of package 105 (FIG. 1B). The monitoring can be part of power management in device 101. For example, sensor 231 can monitor changes (e.g., voltage droops) in the level of the voltage at node 111. Based on the monitoring, sensor 231 can alert device 101 (or other circuit units of the system on package 105) if the voltage at node 111 decreases below a selected level (e.g., a critical level) or increase to a level that is higher than a certain specification, so that appropriate actions can be performed.

Clamp circuit 221 of ESD protection circuitry 120 can operate during an ESD event at node 111 to form part of a circuit path (e.g., current path) 271A (from node 111 and going through diode D2) to discharge (e.g., sink) current from node 111 to ground node 290 through circuit path 271A. Clamp circuit 222 can operate during an ESD event at node 112 to form part of a circuit path (e.g., current path) 272A (from node 112 and going through diode D4) to discharge (e.g., sink) current from node 112 to ground node 290 through circuit path 272A. Clamp circuit 223 can operate during an ESD event at node 113 to form part of a circuit path (e.g., current path) 273A (from node 113 and going through diode D6) to discharge (e.g., sink) current from node 113 to ground node 290 through circuit path 273A.

Current limiting circuitry 140 can include current limiting circuits 241, 242, and 243 coupled between node 291 and nodes 251, 252, and 253, respectively. Current limiting circuits 241, 242, and 243 can include resistors R1, R2, and R3, respectively. Resistors R1, R2, and R3 can have the same resistance or different resistances. As shown in FIG. 2, each of resistors R1, R2, and R3 has a terminal coupled to node 291 and a terminal coupled to one of nodes 251, 252, and 253.

Current limiting circuit 241 can be part of a circuit path (e.g., current path) 271B (from node 111 to node 291) that includes diode D2 and resistor R1. During particular operations (e.g., during a non-ESD events) of device 101, current limiting circuit 241 can operate to control (e.g., reduce or limit) the amount of current that may flow from node 111 to node 291 through circuit path 271B. This control of the current by current limiting circuit 241 can prevent electrical stress and physical damage in circuit elements coupled to node 111.

Current limiting circuit 242 can include a circuit path (e.g., current path) 272B (from node 112 to node 291) that includes diode D4 and resistor R2. During particular operations (e.g., during a non-ESD events) of device 101, current limiting circuit 242 can operate to control (e.g., reduce or limit) the amount of current that may flow from node 112 to node 291 through circuit path 272B. This control of the current by current limiting circuit 242 can prevent electrical stress and physical damage in circuit elements coupled to node 112.

Current limiting circuit 243 can include a circuit path (e.g., current path) 273B (from node 113 to node 291) that includes diode D6 and resistor R3. During particular operations (e.g., during a non-ESD events) of device 101, current limiting circuit 243 can operate to control (e.g., reduce or limit) the amount of current that may flow from node 113 to node 291 through circuit path 273B. This control of the current by current limiting circuit 243 can prevent electrical stress and physical damage in circuit elements coupled to node 113.

As discussed below, without current limiting circuitry 140, the amount of current (e.g., during non-ESD events) from nodes 111, 112, and 113 to node 291, during a non-ESD events at nodes 111, 112, and 113, respectively, may damage electrical connections or circuit paths coupled to nodes 111, 112, and 113. The following description describes example situations where part of device 101 coupled to nodes 111, 112, and 113 can be damaged if current limiting circuitry 140 is omitted from (not included in) device 101.

In FIG. 2, clamp circuit 221 can be configured to be activated and respond to ESD events based on the transient associated with typical ESD events at node 111. For example, clamp circuit 221 can be configured to be activated (to discharge current) in response to "fast transients" (e.g., rate of voltage change), which are typical characteristic of ESD events. A fast transient is normally expected to be events (e.g., ESD events) that can change IV in nanoseconds. Thus, a typical ESD event occurring at node 111 would cause a fast transient at node 111. This activates clamp circuit 221 to allow current from node 111 to flow to ground node 290 through clamp circuit 221 via circuit path 271A. Therefore, circuit elements (e.g., sensor 231) and other circuit elements coupled to node 111 are protected from the ESD event at node 111. However, as discussed below, damage may occur to circuit elements coupled to node 111 if current limiting circuit 241 is not included in device 101 (e.g., if node 251 is directly coupled to node 291).

Clamp circuit 221 may not respond to "slower transients" because they are configured respond to "fast transients", as described above. Slower transients are (or are deemed to be) non-ESD events. A slower transient can include a ramping up (e.g., not a spike) or ramping down of supply power (e.g., voltage Vcc) or signals (e.g., data signals). For example, device 101 can include a power-up stage where the voltage (e.g., voltage Vcc) at node 111 may slowly ramp up. In another example, device 101 can include a power-down stage where the voltage (e.g., voltage Vcc) at node 111 may slowly ramp-down (e.g., due to a relatively large capacitance at node 111). Clamp circuit 221 may not be activated to respond to slower transients that are deemed to be non-ESD events. Thus, clamp circuit 221 may not be activated if a non-ESD event occurs at node 111 where the voltage (e.g., voltage Vcc) at node 111 ramps up slowly. During a non-ESD event at node 111, the value of the voltage at node 111 can be greater than the value of the voltage (e.g., voltage VDD) at node 291 by an amount that is more than the diode turn-on bias voltage of diode D2. Thus, during this non-ESD event, diode D2 could be in a forward-bias state (e.g., turned on). This creates a short circuit between nodes 111 and node 291 and a relatively large amount of current may flow on the shorted path. Prolonged duration of such shorted path and the high amount of current can cause electric stress in the shorted path and may damage circuit elements coupled to this shorted path.

However, as described above, current limiting circuit 241 can operate to limit (e.g., reduce) the current amount on circuit path 272B during a non-ESD event at node 111 if diode D2 is turned on. In comparison with the example where current limiting circuit 241 is not included in device 101, the amount of current from node 111 to node 291 can be significantly lower in the presence of current limiting circuit 241 in device 101. This can allow device 101 to sustain a relatively longer period during a non-ESD event at node 111 without (or with insignificant) electrical stress and physical damage.

The above description describes current limiting circuit 241 and its operations during non-ESD events at node 111. Similarly, current limiting circuits 242 and 243 can have similar operations during non-ESD events at nodes 112 and 113, respectively.

For example, without current limiting circuit 242 (e.g., node 252 is directly coupled to node 291), diode D4 may be in the forward-bias state during a non-ESD event at node 112. For example, the voltage level of the signal (e.g., data signal) at node 112 may be greater than the level of voltage VDD at node 291 for a particular period during a non-ESD event at node 112. Such a particular period can occur during ramping up in a power-up stage of device 101 when the level of voltage VDD at node 291 may still be at relatively low level and not at its target level (e.g., level used as operating voltage for functional unit 232). Thus, during a non-ESD event, the voltage level of the signal (e.g., data signal) at node 112 is may be greater than the level of voltage VDD at node 291 by an amount more than the diode turn-on bias voltage of diode D4. This can create a short circuit between nodes 112 and 291 and a relatively large amount of current may flow on the shorted path. Prolonged duration of such shorted path and the high amount of current can cause electric stress in the shorted path and may damage to circuit elements coupled to this shorted path. However, like current limiting circuit 241 described above, current limiting circuit 242 can operate to limit (e.g., reduce) the current amount on circuit path 272B during a non-ESD event at node 112 if diode D4 is turned on. In comparison with the example where current limiting circuit 242 is not included in device 101, the amount of current from node 112 to node 291 can be significantly lower with the presence of current limiting circuit 242 in device 101. This can allow device 101 to sustain a relatively longer period during a non-ESD event at node 112 without (or with insignificant) electrical stress and physical damage.

In another example, without current limiting circuit 243 (e.g., node 253 is directly coupled to node 291), diode D6 may be in the forward-bias state during a non-ESD event at node 113. For example, the voltage level of the signal (e.g., data signal) at node 113 may be greater than the level of voltage VDD at node 291 for a particular period during a non-ESD event at node 113. Such a particular period can occur during ramping up in a power-up stage of device 101 when the level of voltage VDD at node 291 may still be at relatively low level and not at its target level (e.g., level used as operating voltage for functional unit 233). Thus, during a non-ESD event, the voltage level of the signal (e.g., data signal) at node 113 is may be greater than the level of voltage VDD at node 291 by an amount more than the diode turn-on bias voltage of diode D6. This can create a short circuit between nodes 113 and 291 and a relatively large amount of current may flow on the shorted path. Prolonged duration of such shorted path and the high amount of current can cause electric stress in the shorted path and may damage to circuit elements coupled to this shorted path. However, like current limiting circuit 241 described above, current limiting circuit 243 can operate to limit (e.g., reduce) the current amount on circuit path 273B during a non-ESD event at node 113 if diode D6 is turned on. In comparison with the example where current limiting circuit 243 is not included in device 101, the amount of current from node 113 to node 291 can be significantly lower with the presence of current limiting circuit 243 in device 101. This can allow device 101 to sustain a relatively longer period during a non-ESD event at node 113 without (or with insignificant) electrical stress and physical damage.

Device 101 as described above have improvements and benefits over some conventional devices. For example, some conventional devices have clamp circuits as part of ESD protection circuitry. Such clamp circuits are typically configured to respond to fast transients associated with ESD events and form a circuit path to ground as part of ESD protection operation during such ESD events. Clamp circuits in the conventional devices are typically not designed to respond slow transients (e.g., ramping-up of supply voltage) associated with non-ESD events. Thus, in non-ESD events, the clamp circuits in the conventional devices may not create a circuit path to ground. This can cause a relatively high amount of current to develop in certain circuit paths associated with non-ESD events in the conventional devices, thereby causing electrical stress and potential physical damage in the conventional devices. In contrast, device 101 as described above can include current limiting circuitry (e.g., current limiting circuitry 140) that can operate to prevent electrical stress and physical damage in device 101 during non-ESD events.

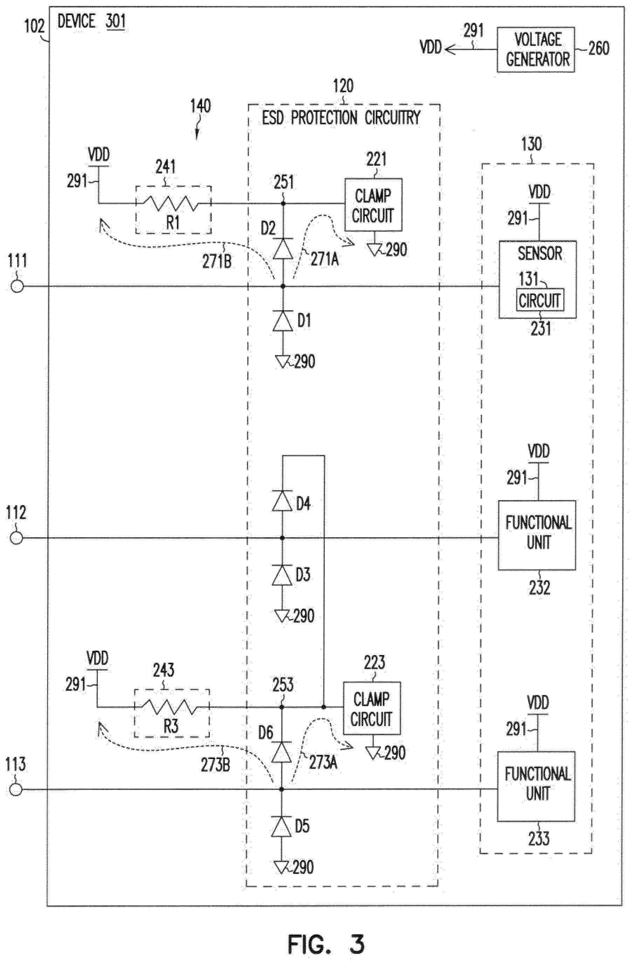

FIG. 3 shows device 301 including ESD protection circuitry 120 and shared current limiting circuitry 243, according to some embodiments described herein. Device 301 can be a variation of device 101 described above with reference to FIG. 1A through FIG. 2. For simplicity, similar or identical elements between devices 101 and 301 are given the same labels and their description is not repeated.

As shown in FIG. 3, the ESD protection circuit at node 112 (which includes diodes D3 and D4) can share clamp circuit 223 and current limiting circuit 243 with the ESD protection circuit at node 113 (which includes diodes D5 and D6). Clamp circuit 223 and current limiting circuit 243 can have the same operations during ESD and non-ESD events at node 113, as described above with reference to FIG. 2. In FIG. 3, during an ESD event at node 112, clamp circuit 223 can operate to form a circuit path from node 112 through diode D4 and clamp circuit 223 to ground node 290. During a non-ESD event at node 112, current limiting circuit 243 can operate to control (e.g., reduce or limit) the amount of current on a circuit path from node 112 through diode D4 and resistor R3 to node 291. This control of the current by current limiting circuit 243 (shared current limiting circuit) can prevent electrical stress and physical damage in circuit elements coupled to node 112. Device 301 can have improvements and benefits over some conventional devices similar to that of device 101.

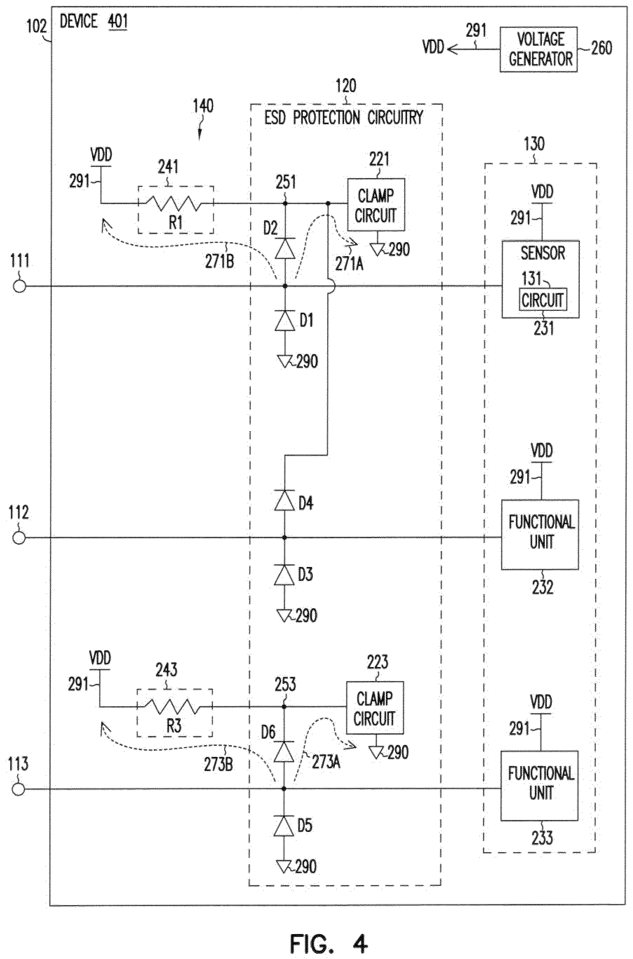

FIG. 4 shows device 401 including ESD protection circuitry 120 and shared current limiting circuitry 241, according to some embodiments described herein. Device 401 can be a variation of device 101 described above with reference to FIG. 1A through FIG. 2. For simplicity, similar or identical elements between devices 101 and 401 are given the same labels and their description is not repeated.

As shown in FIG. 4, the ESD protection circuit at node 112 (which includes diodes D3 and D4) can share clamp circuit 221 and current limiting circuit 241 with the ESD protection circuit at node 111 (which includes diodes D1 and D2). Clamp circuit 221 and current limiting circuit 241 can have the same operations during ESD and non-ESD events at node 111, as described above with reference to FIG. 2. In FIG. 4, during an ESD event at node 112, clamp circuit 221 can operate to form a circuit path from node 112 through diode D4 and clamp circuit 221 to ground node 290. During a non-ESD event at node 112, current limiting circuit 241 can operate to control (e.g., reduce or limit) the amount of current on a circuit path from node 112 through diode D4 and resistor R1 to node 291. This control of the current by current limiting circuit 241 (shared current limiting circuit) can prevent electrical stress and physical damage in circuit elements coupled to node 112. Device 401 can have improvements and benefits over some conventional devices similar to that of device 101.

The description above with reference to FIG. 3 and FIG. 4 shows examples of ESD protection circuits at two nodes (e.g., nodes 111 and 112, or nodes 112 and 113) of device 101 sharing a clamp circuit (e.g., clamp circuit 221 or 223) and a current limiting circuit (e.g., current limiting circuit 241 or 243). However, ESD protection circuits at more than two nodes of device 101 can share a clamp circuit and a current limiting circuit. For example, in FIG. 4, clamp circuit 223 and current limiting circuit 243 can be omitted, and node 253 can be coupled to node 251.

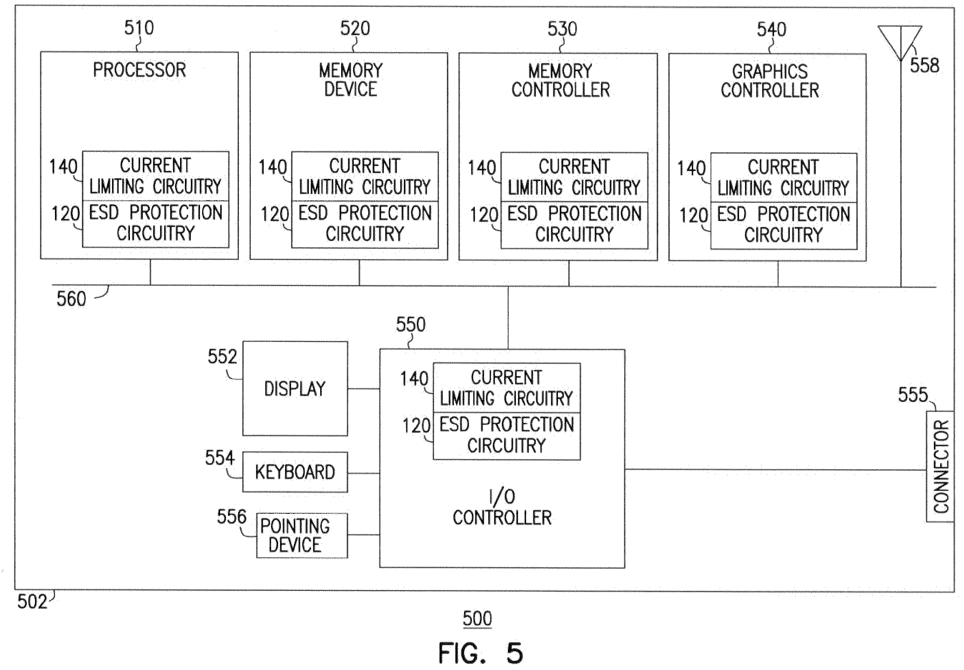

FIG. 5 shows an apparatus in the form of a system (e.g., electronic system) 500, according to some embodiments described herein. System 500 can include or be included in a computer, a tablet, or other electronic system. As shown in FIG. 5, system 500 can include components located on a circuit board (e.g., printed circuit board (PCB)) 502, such as a processor 510, a memory device 520, a memory controller 530, a graphics controller 540, an I/O controller 550, a display 552, a keyboard 554, a pointing device 556, at least one antenna 558, a connector 555, and a bus 560. Bus 560 can include conductive lines (e.g., metal-based traces on a circuit board where the components of system 500 are located).

In some arrangements, system 500 does not have to include a display. Thus, display 552 can be omitted from system 500. In some arrangements, system 500 does not have to include any antenna. Thus, antenna 558 can be omitted from system 500. In some arrangements, system 500 does not have to include a connector. Thus, connector 555 can be omitted from system 500.

Processor 510 can include a general-purpose processor, an application specific integrated circuit (ASIC), or other kinds of processors. Processor 510 can include a CPU.

Memory device 520 can include a dynamic random access memory (DRAM) device, a static random access memory (SRAM) device, a flash memory device, phase change memory, a combination of these memory devices, or other types of memory. FIG. 5 shows an example where memory device 520 is a stand-alone memory device separated from processor 510. In an alternative arrangement, memory device 520 and processor 510 can be located on the same die. In such an alternative arrangement, memory device 520 is an embedded memory in processor 510, such as embedded DRAM (eDRAM), embedded SRAM (eSRAM), embedded flash memory, or another type of embedded memory.

Display 552 can include a liquid crystal display (LCD), a touchscreen (e.g., capacitive or resistive touchscreen), or another type of display. Pointing device 556 can include a mouse, a stylus, or another type of pointing device.

I/O controller 550 can include a communication module for wired or wireless communication (e.g., communication through one or more antenna 558). Such wireless communication may include communication in accordance with WiFi communication technique, Long Term Evolution Advanced (LTE-A) communication technique, or other communication techniques.

I/O controller 550 can also include a module to allow system 500 to communicate with other devices or systems in accordance with to one or more of the following standards or specifications (e.g., I/O standards or specifications), including Universal Serial Bus (USB), DisplayPort (DP), High-Definition Multimedia Interface (HDMI), Thunderbolt, Peripheral Component Interconnect Express (PCIe), Ethernet, and other specifications.

Connector 555 can be arranged (e.g., can include terminals, such as pins) to allow system 500 to be coupled to an external device (or system). This may allow system 500 to communicate (e.g., exchange information) with such a device (or system) through connector 555. Connector 555 and at least a portion of bus 560 can include conductive lines that conform with at least one of USB, DP, HDMI, Thunderbolt, PCIe, Ethernet, and other specifications.

As shown in FIG. 5, each of processor 510, memory device 520, memory controller 530, graphics controller 540, and I/O controller 550 can include ESD protection circuitry 120 and current limiting circuitry 140 described above with reference to FIG. 1 through FIG. 4. FIG. 5 shows each of processor 510, memory device 520, memory controller 530, graphics controller 540, and I/O controller 550 including ESD protection circuitry 120, as an example. However, fewer than all of processor 510, memory device 520, memory controller 530, graphics controller 540, and I/O controller 550 can include ESD protection circuitry 120 current limiting circuitry 140.

FIG. 5 shows the components of system 500 arranged separately from each other as an example. For example, each of processor 510, memory device 520, memory controller 530, graphics controller 540, and I/O controller 550 can be located on a separate IC (e.g., semiconductor die or an IC chip). In some arrangements, two or more components (e.g., processor 510, memory device 520, graphics controller 540, and I/O controller 550) of system 500 can be located on the same die (e.g., same IC chip) that can be part of a system on chip, a system in a package, or other electronic devices or systems,

The illustrations of the apparatuses (e.g., devices 101, 301, and 401 and system 500 including, ESD protection circuitry 120 and current limiting circuitry 140) described above are intended to provide a general understanding of the structure of different embodiments and are not intended to provide a complete description of all the elements and features of an apparatus that might make use of the structures described herein.

The apparatuses and methods described above can include or be included in high-speed computers, communication and signal processing circuitry, single-processor module or multi-processor modules, single embedded processors or multiple embedded processors, multi-core processors, message information switches, and application-specific modules including multilayer or multi-chip modules. Such apparatuses may further be included as sub-components within a variety of other apparatuses (e.g., electronic systems), such as televisions, cellular telephones, personal computers (e.g., laptop computers, desktop computers, handheld computers, etc.), tablets (e.g., tablet computers), workstations, radios, video players, audio players (e.g., MP3 (Motion Picture Experts Group, Audio Layer 3) players), vehicles, medical devices (e.g., heart monitors, blood pressure monitors, etc.), set top boxes, and others.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, a list of items joined by the term "at least one of" can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of" can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

### Additional Notes and Examples

Example 1 includes subject matter (such as a device, an electronic apparatus (e.g., circuit, electronic system, or both), or a machine) including an input node, an electrostatic discharge protection circuitry including first diode including a cathode coupled to the input node, and an anode coupled to a ground node, a second diode including an anode coupled to the input node, and a cathode coupled to a circuit node, a clamp circuit coupled to the circuit node, and a current limiting circuit coupled between the circuit node and a supply node.
In Example 2, the subject matter of Example 1 may optionally include, wherein the current limiting circuit includes a resistor, the resistor includes a first terminal coupled to the circuit node, and a second terminal coupled to the supply node.
In Example 3, the subject matter of Example 1 may optionally include, wherein the input node is coupled to an additional supply node.
In Example 4, the subject matter of Example 3 may optionally include, further comprising a voltage generator, the voltage generator including an output node coupled to the supply node.
In Example 5, the subject matter of Example 3 may optionally include, wherein the electrostatic discharge protection circuitry and the current limiting circuit are located on a die of an integrated circuit, and the additional supply node is part of a conductive connection on a package of the integrated circuit.
In Example 6, the subject matter of Example 3 may optionally include, wherein the conductive connection includes a controlled collapse chip connection (C4) structure.
In Example 7, the subject matter of Example 3 may optionally include, further comprising a sensor circuit coupled to the input node to sense a voltage level of a voltage at the input node.
In Example 8, the subject matter of Example 7 may optionally include, wherein the current limiting circuit is configured to be part of a circuit path between the input node and the supply node during a non- electrostatic discharge at the input supply node.
Example 9 includes subject matter (such as a device, an electronic apparatus (e.g., circuit, electronic system, or both), or a machine) including a first input node, a second input node, an electrostatic discharge protection circuitry including a first diode including a cathode coupled to the first input node, and an anode coupled to a ground node, a second diode including an anode coupled to the first input node, and a cathode coupled to a first circuit node, a first clamp circuit coupled to the first circuit node, a third diode including a cathode coupled to the second input node, and an anode coupled to the ground node, a second diode including an anode coupled to the second input node, and a cathode coupled to a second circuit node, a second clamp circuit coupled to the second circuit node, a first current limiting circuit coupled between the first circuit node and a supply node, and a second current limiting circuit coupled between the second circuit node and the supply node.
In Example 10, the subject matter of Example 9 may optionally include, wherein the first current limiting circuit includes a resistor, the resistor includes a first terminal coupled to the first circuit node, and a second terminal coupled to the supply node.
In Example 11, the subject matter of Example 10 may optionally include, wherein resistor is the first resistor, and the second current limiting circuit includes a second resistor, the second resistor includes a first terminal coupled to the second circuit node, and a second terminal coupled to the supply node.
In Example 12, the subject matter of Example 11 may optionally include, wherein the first and second resistors have a same resistance.
In Example 13, the subject matter of Example 9 may optionally include, wherein the first current limiting circuit is configured to be part of a circuit path between the first input node and the supply node during a non-electrostatic discharge event at the first input node.
In Example 14, the subject matter of Example 3 may optionally include, wherein the second current limiting circuit is configured to be part of a circuit path between the second input node and the supply node during a non-electrostatic discharge event at the second input node.
Example 15 includes subject matter (such as a device, an electronic apparatus (e.g., circuit, electronic system, or both), or a machine) including a first input node, a second input node, an electrostatic discharge protection circuitry including a first diode including a cathode coupled to the first input node, and an anode coupled to a ground node, a second diode including an anode coupled to the first input node, and a cathode coupled to a circuit node, a clamp circuit coupled to the circuit node, a third diode including a cathode coupled to the second input node, and an anode coupled to the ground node, a fourth diode including an anode coupled to the second input node, and a cathode coupled to the circuit node, and a current limiting circuit coupled between the circuit node and a supply node.
In Example 16, the subject matter of Example 15 may optionally include, wherein the current limiting circuit includes a resistor, the resistor includes a first terminal coupled to the circuit node, and a second terminal coupled to the supply node.
In Example 17, the subject matter of Example 16 may optionally include, wherein the current limiting circuit is configured to be part of a circuit path between the first input node and the supply node during a non-electrostatic discharge event at the first input node.
In Example 18, the subject matter of Example 17 may optionally include, wherein the second current limiting circuit is configured to be part of a circuit path between the second input node and the supply node during a non-electrostatic discharge event at the second input node.
Example 19 includes subject matter (such as a device, an electronic apparatus (e.g., circuit, electronic system, or both), or a machine) including a processor including an input node, an electrostatic discharge protection circuitry including a first diode including a cathode coupled to the input node, and an anode coupled to a ground node, a second diode including an anode coupled to the input node, and a cathode coupled to a circuit node, a clamp circuit coupled to the circuit node, and a current limiting circuit coupled between the circuit node and a supply node, and a connector coupled to the processor.
In Example 20, the subject matter of Example 18 may optionally include, wherein the connector conforms with one of Universal Serial Bus (USB), High-Definition Multimedia Interface (HDMI), Thunderbolt, Peripheral Component Interconnect Express (PCIe), and Ethernet specifications.

The subject matter of Example 1 through Example 20 may be combined in any combination.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description.

The Abstract is provided to comply with 37 C.F.R. Section 1.72(b) requiring an abstract that will allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. An apparatus comprising:
an input node;
an electrostatic discharge protection circuitry including:
a first diode including a cathode coupled to the input node, and an anode coupled to a ground node;
a second diode including an anode coupled to the input node, and a cathode coupled to a circuit node;
a clamp circuit coupled to the circuit node; and
a current limiting circuit coupled between the circuit node and a supply node.

2. The apparatus of claim 1, wherein the current limiting circuit includes a resistor, the resistor includes a first terminal coupled to the circuit node, and a second terminal coupled to the supply node.

3. The apparatus of claim 1, wherein the input node is coupled to an additional supply node.

4. The apparatus of claim 3, further comprising a voltage generator, the voltage generator including an output node coupled to the supply node.

5. The apparatus of claim 1, wherein the electrostatic discharge protection circuitry and the current limiting circuit are located on a die of an integrated circuit, and the additional supply node is part of a conductive connection on a package of the integrated circuit.

6. The apparatus of claim 5, wherein the conductive connection includes a controlled collapse chip connection (C4) structure.

7. The apparatus of claim 1, further comprising a sensor circuit coupled to the input node to sense a voltage level of a voltage at the input node.

8. The apparatus of claim 1, wherein the current limiting circuit is configured to be part of a circuit path between the input node and the supply node during a non-electrostatic discharge at the input supply node.

9. The apparatus of claim 1 further comprising:
a second input node;
a third diode including a cathode coupled to the second input node, and an anode coupled to the ground node;
a fourth diode including an anode coupled to the second input node, and a cathode coupled to a second circuit node;
a second clamp circuit coupled to the second circuit node; and
a second current limiting circuit coupled between the second circuit node and the supply node.

10. The apparatus of claim 9, wherein the first current limiting circuit includes a resistor, the resistor includes a first terminal coupled to the first circuit node, and a second terminal coupled to the supply node, and the second current limiting circuit includes a second resistor, the second resistor includes a first terminal coupled to the second circuit node, and a second terminal coupled to the supply node.

11. The apparatus of claim 10, wherein the first and second resistors have a same resistance.

12. The apparatus of claim 9, wherein the first current limiting circuit is configured to be part of a circuit path between the first input node and the supply node during a non-electrostatic discharge event at the first input node and the second current limiting circuit is configured to be part of a circuit path between the second input node and the supply node during a non-electrostatic discharge event at the second input node.

13. The apparatus of claim 1 further comprising:
a second input node;
a third diode including a cathode coupled to the second input node, and an anode coupled to the ground node; and
a fourth diode including an anode coupled to the second input node, and a cathode coupled to the circuit node.

14. The apparatus of claim 1 further comprising:
a processor, the processor including:
the input node;
the electrostatic discharge protection circuitry; and
the current limiting circuit; and
a connector coupled to the processor.

15. The apparatus of claim 14, wherein the connector conforms with one of Universal Serial Bus (USB), High-Definition Multimedia Interface (HDMI), Thunderbolt, Peripheral Component Interconnect Express (PCIe), and Ethernet specifications.
